# EUROPEAN PATENT APPLICATION

(11) **EP 4 576 975 A1**
(43) Date of publication of application: **25.06.2025**
(21) Application number: 24198632.2
(22) Date of filing: 05.09.2024
(51) Int. Cl.: H10B 12/00, H01L 23/525

(54) **SEMICONDUCTOR MEMORY DEVICE**

(30) Priority: 22.12.2023 KR 20230190172
(71) Applicant: Samsung Electronics Co., Ltd., Gyeonggi-do, 16677 (KR)
(72) Inventor: HAN, Joon, 16677 Suwon-si (KR); LEE, Sangho, 16677 Suwon-si (KR); JEONG, Moonyoung, 16677 Suwon-si (KR)
(74) Representative: Marks & Clerk LLP

(57) **Abstract**

A semiconductor memory device includes a first structure on a substrate and including core regions and a first peripheral circuit region, and a second structure on the first structure and including cell array regions and a second peripheral circuit region. The second structure includes a first active pattern in each of the cell array regions and perpendicular to an upper surface of the first structure, a word line adjacent to one side of the first active pattern and extending in a first direction parallel to the upper surface of the first structure, a bit line in contact with a lower surface of the first active pattern and extending in a second direction intersecting the first direction, a second active pattern in the second peripheral circuit region and perpendicular to the upper surface of the first structure, and an anti-fuse gate electrode on one side of the second active pattern.

## Description

### BACKGROUND

The inventive concept relates generally to a semiconductor memory device, and more particularly, relates to a semiconductor memory device including vertical channel transistors and a method of manufacturing the same.

When any one failed unit cell from among numerous unit cells of a semiconductor memory device is detected during a fabrication process of the semiconductor memory device, the semiconductor memory device is typically discarded as a defective product. However, it is inefficient to discard the semiconductor memory device as a defective product even though defects occur in only some unit cells thereof. The semiconductor memory device may be restored by replacing the failed unit cells with redundancy cells prepared therein, which makes it possible to improve product yield.

### SUMMARY

An object of the inventive concept is to provide to a semiconductor memory device with improved electrical characteristics and integration.

The problem to be solved by the inventive concept is not limited to the problems mentioned above, and other problems not mentioned will be clearly understood by those skilled in the art from the description below.

A semiconductor memory device according to some embodiments of the inventive concept includes a substrate, a first structure on the substrate and including core regions and a first peripheral circuit region, and a second structure on the first structure and including cell array regions and a second peripheral circuit region between the cell array regions, wherein the second structure includes a first active pattern in each of the cell array regions and perpendicular to an upper surface of the first structure, a word line adjacent to one side of the first active pattern and extending in a first direction parallel to the upper surface of the first structure, a bit line in contact with a lower surface of the first active pattern and extending in a second direction intersecting the first direction, a second active pattern in the second peripheral circuit region and perpendicular to the upper surface of the first structure, and an anti-fuse gate electrode on one side of the second active pattern.

A semiconductor memory device according to some embodiments of the inventive concept includes a substrate and a first structure on the substrate and including cell array regions and a first peripheral circuit region between the cell array regions, wherein the first structure includes a first word line, a first active pattern, a back gate line, a second active pattern and a second word line arranged side-by-side (i.e., proximate to one another) in the cell array region in a first direction parallel to an upper surface of the substrate and an anti-fuse gate electrode, a third active pattern, and a first peripheral back gate electrode arranged side-by-side in the first direction in the first peripheral circuit region, and the first active pattern, the second active pattern, and the third active pattern extend longitudinally in a direction perpendicular to the upper surface of the substrate.

A semiconductor memory device according to some embodiments of the inventive concept includes a substrate, a first structure on the substrate and including core regions and a first peripheral circuit region, and a second structure on the first structure and including cell array regions and a second peripheral circuit region between the cell array regions, wherein the cell array regions at least partially vertically overlap the core regions, respectively, wherein the second peripheral circuit region at least partially vertically overlaps the first peripheral circuit region, the second structure includes a bit line extending in a first direction in the cell array region, a first word line, a first gate insulating layer, a first active pattern, a back gate line, a second active pattern, and a second word line arranged side-by-side in the first direction on the bit line, a conductive line in the second peripheral circuit region, an anti-fuse gate electrode, a second gate insulating layer, a third active pattern, and a first peripheral back gate electrode arranged side-by-side on the conductive line, the first active pattern, the second active pattern, and the third active pattern extend longitudinally in a vertical direction from the upper surface of the substrate, the first word line, the back gate line, and the second word line extend in a second direction that intersects the first direction and is parallel to the upper surface of the substrate, the first gate insulating layer has a first thickness, and the second gate insulating layer has a second thickness that is equal to or smaller than the first thickness.

At least some of the above and other features of the invention are set out in the claims.

### BRIEF DESCRIPTION OF THE DRAWINGS

Example embodiments will be more clearly understood from the following brief description taken in conjunction with the accompanying drawings, wherein like reference numerals (when used) indicate corresponding elements throughout the several views. The accompanying drawings represent non-limiting, example embodiments as described herein.
FIG. 1A is a block diagram of at least a portion of an example semiconductor memory device including a semiconductor device according to embodiments of the inventive concept.
FIG. 1B is a schematic perspective view of at least a portion of an example semiconductor memory device according to embodiments of the inventive concept.
FIG. 2 is a schematic perspective view of a semiconductor memory device according to embodiments of the inventive concept.
FIG. 3 is a schematic cross-sectional view taken along line A-A' of the semiconductor memory device depicted in FIG. 2, according to embodiments of the inventive concept.
FIG. 4 shows a schematic top view of a cell array region according to embodiments of the inventive concept.
FIG. 5A is a schematic enlarged cross-sectional view of region 'P1' of the semiconductor memory device depicted in FIG. 3, according to embodiments of the inventive concept.
FIG. 5B is a detailed enlarged cross-sectional view of region 'P I' of the semiconductor memory device depicted in FIG. 3, according to embodiments of the inventive concept.
FIG. 6 is an enlarged view of region `P2' of the semiconductor memory device depicted in FIG. 3, according to embodiments of the inventive concept.
FIG. 7A shows a schematic diagram of an example anti-fuse circuit according to embodiments of the inventive concept.
FIG. 7B is a schematic diagram illustrating a program operation of the anti-fuse transistor of FIG. 6.
FIG. 8 is an enlarged view of region `P2' of the semiconductor memory device depicted in FIG. 3, according to embodiments of the inventive concept.
FIG. 9A is an enlarged view of region `P2' of the semiconductor memory device depicted in FIG. 3, according to embodiments of the inventive concept.
FIG. 9B is a schematic diagram illustrating a program operation of the anti-fuse transistor of FIG. 9A.
FIG. 10 is a schematic cross-sectional view illustrating a portion of a semiconductor memory device according to embodiments of the inventive concept.

### DETAILED DESCRIPTION

Hereinafter, with reference to the drawings, a semiconductor memory device and a method of manufacturing the same according to embodiments of the inventive concept will be described in detail. In this specification, ordinal terms such as first, second, etc. may be used herein to distinguish components from one another that perform the same/similar functions, and their numbers may change depending on the order in which they are mentioned. However, it is to be appreciated that such ordinal terms are not intended to convey any particular order of the elements unless specifically stated.

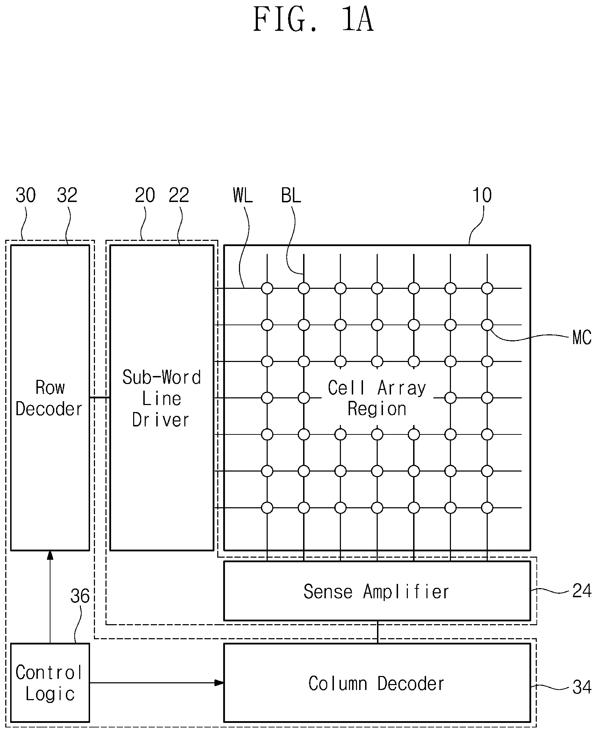

FIG. 1A is a block diagram of at least a portion of an example semiconductor memory device including a semiconductor device according to embodiments of the inventive concept.

Referring to FIG. 1A, a semiconductor memory device according to this example may include a cell array region 10. Word lines WL and bit lines BL that intersect each other may be arranged in the cell array region 10. A plurality of memory cells MC may be arranged two-dimensionally or three-dimensionally in the cell array region 10. Each of the memory cells MC may be connected between the word line WL and the bit line BL that intersect each other.

A core region 20 may be disposed around the cell array region 10. A sub-word line driver 22 and a sense amplifier 24 may be disposed in the core region 20. A peripheral circuit region 30 may be disposed around the core region 20. A row decoder 32, a column decoder 34, and control logic 36 may be disposed in the peripheral circuit region 30.

The row decoder 32 may decode an externally input row address signal or refresh address signal. The sub-word line driver 22 may perform a function of selecting a specific word line WL in response to the row address signal or the refresh address signal.

The sense amplifier 24 may detect and amplify a voltage difference between a selected bit line BL and a reference bit line depending on an address decoded from the column decoder 34 and output an amplified voltage difference.

The column decoder 34 may provide a data transmission path between the sense amplifier 24 and an external device (e.g., memory controller, not explicitly shown). The column decoder 34 may decode an externally input column address signal to select one of the bit lines BL.

The control logic 36 may generate control signals that control operations for writing or reading data into the memory cell array of the cell array region 10.

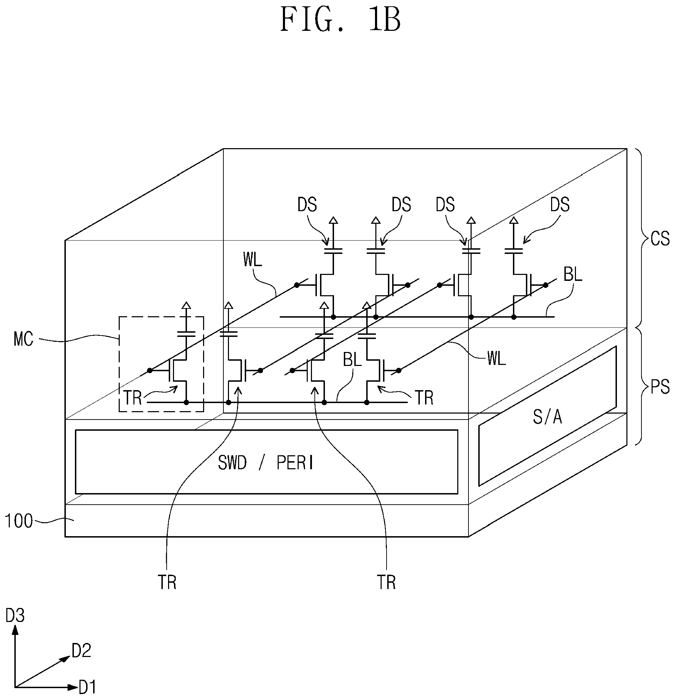

FIG. 1B is a schematic perspective view of at least a portion of an example semiconductor memory device according to embodiments of the inventive concept.

Referring to FIG. 1B, a semiconductor memory device may include a substrate 100, a first structure PS, and a second structure CS that are sequentially stacked in a direction (D3) perpendicular to an upper surface of the substrate 100. Unlike FIG. 1B, the second structure CS may be disposed between the substrate 100 and the first structure PS. The first structure PS may also be called a peripheral circuit structure. The second structure CS may also be called a cell structure.

The first structure PS may include the core region 20 and the peripheral circuit region 30 of FIG. 1A. The core region 20 may include sub-word line driver circuits SWD and a sense amplifier circuit S/A. The peripheral circuit region 30 may include peripheral circuits PERI.

The second structure CS may include the cell array region 10 of FIG. 1A. The second structure CS may include bit lines BL, word lines WL, and memory cells MC therebetween. The memory cells MC may be arranged two-dimensionally or three-dimensionally on a plane extending in first and second directions D1 and D2 that are parallel to the upper surface of the substrate 100 (i.e., horizontal) and intersect each other. Each of the memory cells MC may include a selection element TR and a data storage element DS.

The selection element TR may be a field-effect transistor (FET). A gate electrode of the transistor may be connected to a corresponding one of the word lines WL, and drain/source terminals of the transistor may be connected to a corresponding one of the bit lines BL and the corresponding one of the data storage elements DS, respectively. According to embodiments, the selection element TR of each memory cell MC may be a vertical channel transistor (VCT). The vertical channel transistor may have a structure in which a channel length extends in a direction perpendicular to an upper surface of the substrate 100 (i.e., a third direction D3).

The data storage element DS may be implemented, for example, as a capacitor, magnetic tunnel junction pattern, or variable resistor. In this example, a capacitor may be provided as the data storage element DS of each memory cell MC.

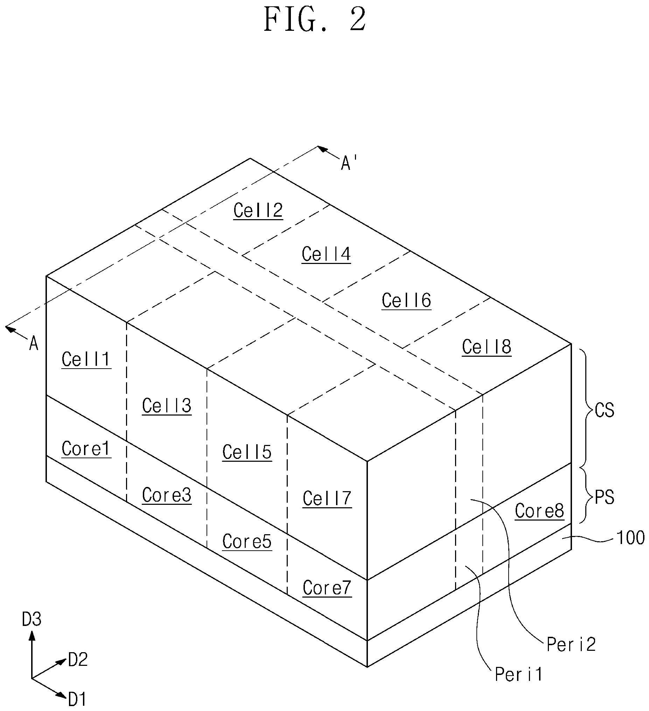

FIG. 2 is a schematic perspective view of a semiconductor memory device according to embodiments of the inventive concept.

Referring to FIG. 2, in a semiconductor memory device, a first structure PS and a second structure CS are sequentially stacked on a substrate 100 in a third direction D3. The first structure PS may also be called a peripheral circuit structure. The second structure CS may also be called a cell structure. The substrate 100 may be a semiconductor substrate, silicon-on-insulator (SOI) substrate, or insulating substrate. The first structure PS includes first to eighth core regions Core1 to Core8 and a first peripheral circuit region Peri1 arranged two-dimensionally in a first direction D1 and a second direction D2. The first, third, fifth, and seventh core regions Core1, Core3, Core5, and Core 7 may be disposed on a front surface of the first structure PS. The second, fourth, sixth, and eighth core regions Core2, Core4, Core6, and Core8 may be disposed on a back surface of the first structure PS opposite the front surface of the first structure PS in the second direction D2. The first peripheral circuit region Peri1 may be disposed between the first, third, fifth, and seventh core regions Core1, Core3, Core5, and Core 7 and the second, fourth, sixth, and eighth core regions Core2, Core4, Core6, and Core8. In this example, eight core regions are disclosed, but the number of core regions is not limited thereto and may be less than eight or more than nine. The arrangement of the first to eighth core regions Core1 to Core8 and the first peripheral circuit region Peri1 is not limited to the arrangement of FIG. 2 and may be variously changed.

The second structure CS includes first to eighth cell array regions Cell1 to Cell8 and a second peripheral circuit region Peri2 arranged two-dimensionally in the first direction D1 and the second direction D2. The first, third, fifth, and seventh cell array regions Cell1, Cell3, Cell5, and Cell7 may be disposed on a front surface of the second structure CS. The second, fourth, sixth, and eighth cell array regions Cell2, Cell4, Cell6, and Cell8 may be disposed on a back surface of the second structure CS opposite the front surface of the second structure CS in the second direction D2. The second peripheral circuit region Peri2 may disposed between the first, third, fifth, and seventh cell array regions Cell1, Cell3, Cell5, and Cell7 and the second, fourth, sixth, and eighth cell array regions Cell2, Cell4, Cell6, and Cell8. In this example, eight cell array regions are disclosed, but the number of cell array regions is not limited thereto and may be less than eight or more than nine. The arrangement of the first to eighth cell array regions Cell1 to Cell8 and the second peripheral circuit region Peri2 is not limited to the arrangement of FIG. 2 and may be variously changed.

The first to eighth cell array regions Cell1 to Cell8 may vertically overlap the first to eighth core regions Core1 to Core8, respectively. The term "overlap" (or "overlapping," or like terms), as may be used herein, is intended to broadly refer to a first element that intersects with at least a portion of a second element in the vertical direction (i.e., the third direction D3), but does not require that the first and second elements be completely aligned with one another in a horizontal plane (i.e., in the first direction D1 and/or the second direction D2). The first to eighth cell array regions Cell1 to Cell8 may be connected to the first to eighth core regions Core1 to Core8, respectively. The second peripheral circuit region Peri2 may vertically overlap the first peripheral circuit region Peri1. The second peripheral circuit region Peri2 may be connected to the first peripheral circuit region Peri1. Each of the first to eighth cell array regions Cell1 to Cell8 may correspond to the cell array region 10 of FIG. 1A. The bit lines BL, word lines WL, and memory cells MC described with reference to FIGS. 1A and 1B may be disposed in each of the first to eighth cell array regions Cell1 to Cell8. The sub-word line driver 22 and the sense amplifier 24 described with reference to FIG. 1A may be disposed in each of the first to eighth core regions Core1 to Core8. The row decoders 32, column decoders 34, and control logic circuits 36 may be disposed in the first peripheral circuit region Peri1 and the second peripheral circuit region Peri2.

In this example, anti-fuse circuits may be disposed in the second peripheral circuit region Peri2. The anti-fuse is a resistive fuse element that has electrical characteristics opposite to those of a fuse. The anti-fuse element may take a form of a transistor including a gate insulating layer and a gate electrode. In normal conditions, the gate insulating layer of the anti-fuse device may be maintained normally. When a defective cell is found when inspecting a semiconductor memory device, a programming operation may be performed to apply a high voltage (breakdown voltage, or fusing voltage) to the gate electrode of the anti-fuse device to destroy the gate insulating layer. As a result, defective cells may be replaced with redundancy cells. Therefore, yield may be improved because there is no need to discard the semiconductor memory device.

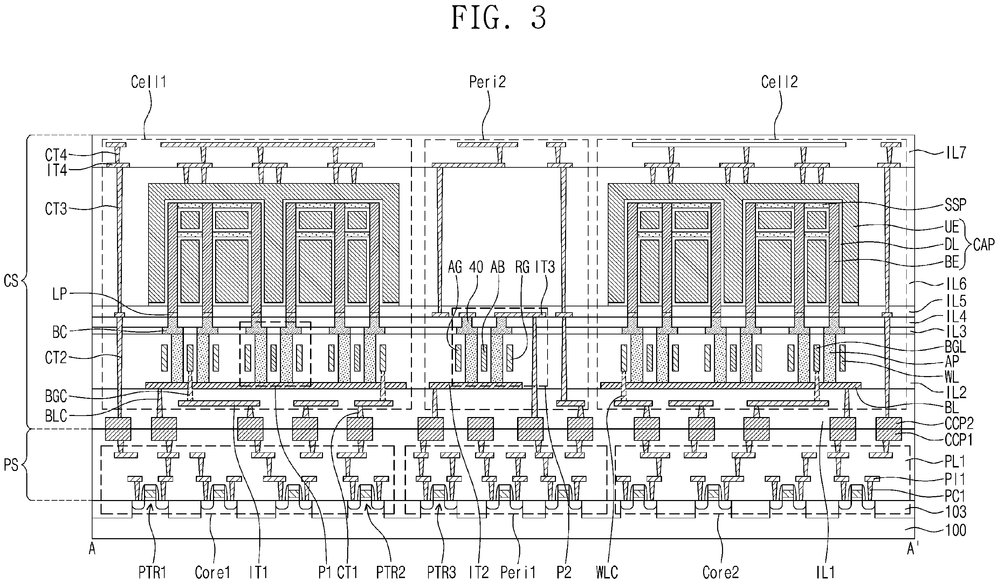

FIG. 3 is a schematic cross-sectional view taken along line A-A' of the semiconductor memory device shown in FIG. 2, according to embodiments of the inventive concept.

Referring to FIGS. 2 and 3, the first structure PS and the second structure CS are sequentially stacked on the substrate 100 in the vertical direction. The substrate 100 may be a semiconductor substrate, silicon-on-insulator (SOI) substrate, or insulating substrate. Device isolation patterns 103 may be disposed on the substrate 100 to define active regions for peripheral transistors PTR1, PTR2, and PTR3. The device isolation patterns 103 may have a single-layer or multi-layer structure of at least one of silicon oxide and silicon nitride.

The first structure PS may include first to third peripheral transistors PTR1, PTR2, and PTR3, lower contact plugs PC1, lower wirings PI1, and a lower insulating layer PL1 disposed on the substrate 100. Each of the first to third peripheral transistors PTR1, PTR2, and PTR3 may have a form of a planar transistor, a fin field-effect transistor (FinFET), a multi-bridge channel FET (MBCFET), a gate all-around (GAA) transistor, or a buried channel array transistor (BCAT). Each of the first to third peripheral transistors PTR1, PTR2, and PTR3 may be connected to the lower contact plugs PC1 and lower wirings PI1. The lower insulating layer PL1 may cover the first to third peripheral transistors PTR1, PTR2, and PTR3, the lower contact plugs PC1, and the lower wiring PI1. Lower connection pads CCP1 are disposed on top of the lower insulating layer PL1. The lower connection pads CCP1 are electrically connected to the lower contact plugs PC1 and lower wirings PI1. The term "connected", the term "contact" (or "connecting," or like terms such as "contact" or "contacting"), as may be used herein, is intended to refer to a physical and/or electrical connection between two or more elements, and may include other intervening elements unless specified otherwise. As used herein, the term "and/or" includes any and all combinations of one or more of the associated listed items.

The lower connection pads CCP1, lower contact plugs PC1, and lower wirings PI1 may each include a metal such as copper, aluminum, tungsten, titanium, tantalum, titanium nitride, or tantalum nitride. The lower insulating layer PL1 may have a single-layer or multi-layer structure of at least one of silicon oxide, silicon nitride, silicon oxynitride, SiCN, and porous insulator.

In each of the core regions Core1 to Core8, the first peripheral transistors PTR1 and the lower contact plugs PC1 and lower wirings PI1 connected thereto may constitute sense amplifiers 24 (see FIG. 1A). In each of the core regions Core1 to Core8, the second peripheral transistors PTR2 and the lower contact plugs PC1 and lower wirings PI1 connected thereto may constitute sub-word line drivers 22 (see FIG. 1A). The third peripheral transistors PTR3 and the lower contact plugs PC1 and lower wirings PI1 connected thereto may be disposed in the first peripheral circuit region Peri1, and may constitute the row decoders 32, column decoders 34, and control logic circuits 36 (see FIG. 1A).

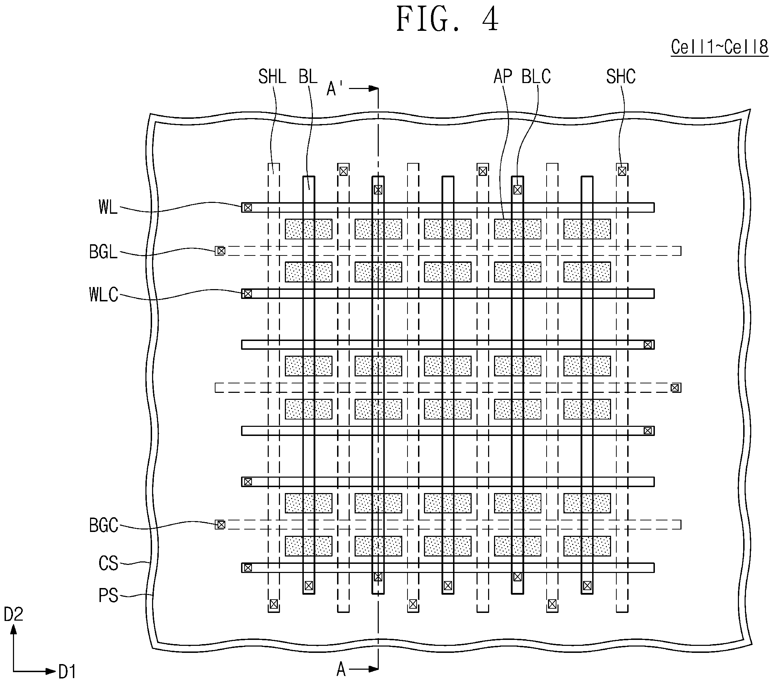

The second structure CS may include sequentially stacked first to seventh upper insulating layers IL1 to IL7, and bit lines BL, shield lines SHL (see FIG. 4), word lines WL, back gate lines BGL and capacitors CAP disposed therein. Each of the first to seventh upper insulating layers IL1 to IL7 may have a single-layer or multi-layer structure of at least one of silicon oxide, silicon nitride, silicon oxynitride, and porous insulator.

First upper wirings IT1 and first upper contact plugs CT1 may be disposed in the first upper insulating layer IL1. Upper connection pads CCP2 may be disposed at a lower end of the first upper insulating layer IL1 and may be in contact with the lower connection pads CCP1, respectively.

FIG. 4 is a schematic top view of at least a portion of a cell array region according to embodiments of the inventive concept. In FIG. 3, the first and second cell array regions Cell1 and Cell2 may correspond to a cross section taken along line A-A' of FIG. 4.

Referring to FIGS. 2 to 4, bit lines BL and shield lines SHL are disposed on the first upper insulating layer IL1 in each of the first to eighth cell array regions Cell1 to Cell8. The bit lines BL and the shield lines SHL may extend in the second direction D2 and be spaced apart from each other in the first direction D1. The shield lines SHL may be interposed between the bit lines BL. The second upper wirings IT2 may be disposed on the first upper insulating layer IL1 in the second peripheral circuit region Peri2. The bit lines BL, shield lines SHL, and second upper wiring IT2 may be positioned at the same level. The bit lines BL, shield lines SHL, and second upper wiring IT2 may be covered with the second upper insulating layer IL2.

Referring to FIGS. 3 and 4, a bit line contact plug BLC may penetrate (i.e., extend into or through) the first upper insulating layer IL1 and may connect ends of the bit lines BL to the upper connection pads CCP2. Although not shown in FIG. 3, the shield line contact plug SHC may penetrate the first upper insulating layer IL1 and may connect ends of the shield lines SHL to the upper connection pads CCP2. The word line contact plug WLC may penetrate a portion of the first upper insulating layer IL1 and the second upper insulating layer IL2 and may connect an end of the word line WL to the first upper wiring IT1. The back gate line contact plug BGC may penetrate a portion of the first upper insulating layer IL1 and the second upper insulating layer IL2 and may connect an end of the back gate line BGL to the first upper wiring IT1.

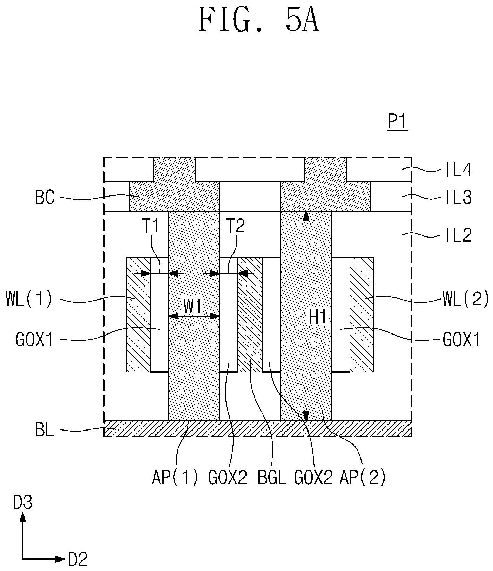

FIG. 5A is a schematic enlarged view of region 'P I' of FIG. 3, according to embodiments of the inventive concept.

Referring to FIGS. 2 to 5A, in each of the first to eighth cell array regions Cell1 to Cell8, active patterns AP may penetrate the second upper insulating layer IL2 to be in contact with the bit lines BL. The active patterns AP may include a pair of first active patterns AP(1) and second active patterns AP(2) adjacent to each other in the second direction D2. The word lines WL may include a pair of first word lines WL(1) and second word lines WL(2) adjacent to each other in the second direction D2. The back gate line BGL is interposed between a pair of first active patterns AP(1) and second active patterns AP(2). The word lines WL and the back gate lines BGL may extend in the first direction D1 as shown in FIG. 4. In one example, the bit line BL may contact a lower surface of the first active pattern AP (1) and may extend in the second direction D2 parallel to the upper surface of the first structure PS and intersecting the first direction D1.

A third upper insulating layer IL3 is disposed on the second upper insulating layer IL2. A fourth upper insulating layer IL4 is disposed on the third upper insulating layer IL3. Storage node contacts BC may penetrate the fourth upper insulating layer IL4 and the third upper insulating layer IL3 and may be in contact with upper ends of the active patterns AP. The storage node contact BC may have a wider width, in the second direction D2, within the third upper insulating layer IL3 than within the fourth upper insulating layer IL4.

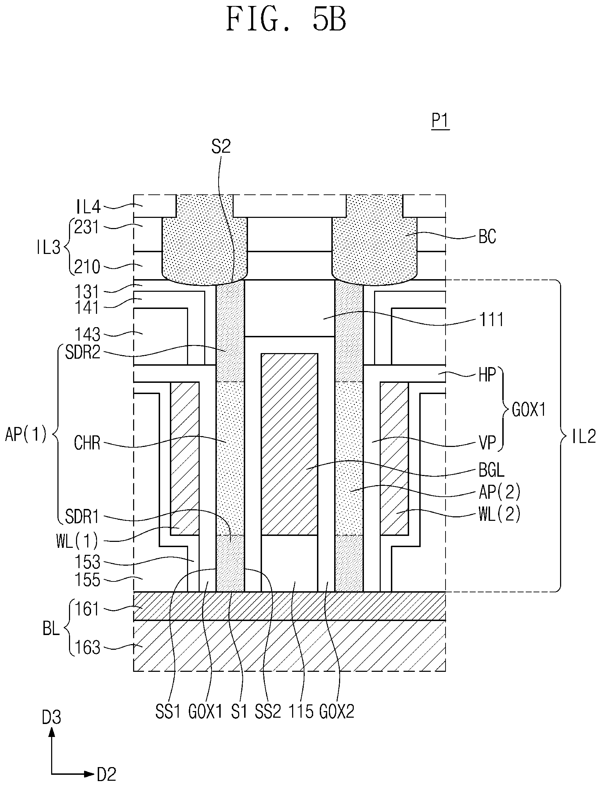

FIG. 5B is a detailed enlarged view of region `P1' of FIG. 3, according to embodiments of the inventive concept.

Referring to FIG. 5B, each of the bit lines BL may include a polysilicon pattern 161 and a metal pattern 163 that are sequentially stacked in the third direction D3. Although not shown in FIG. 5B, each of the shield lines SHL (FIG. 4) may have at least one of a polysilicon pattern 161 and a metal pattern 163. A level of an upper surface of each of the bit lines BL may be the same as or different from a level of an upper surface of each of the shield lines SHL in the third direction D3, relative to the upper surface of the substrate 100 as a reference layer. A level of a lower surface of each of the bit lines BL may be the same as or different from a level of a lower surface of each of the shield lines SHL in the third direction D3, relative to the upper surface of the substrate 100 as a reference layer. The metal pattern 163 may include conductive metal nitride (e.g., titanium nitride, tantalum nitride, etc.) and metal (e.g., tungsten, titanium, tantalum, etc.). The metal pattern 163 may include a metal silicide, such as titanium silicide, cobalt silicide, or nickel silicide.

Referring to FIGS. 5A and 5B, the active patterns AP may be formed of a single crystal semiconductor material. As an example, the active patterns AP may be formed of single crystal silicon. Each of the first active pattern AP(1) and the second active pattern AP(2) may have a length in the first direction D1, a width W1 in the second direction D2, and a height H1 in the third direction D3, perpendicular to the first and second directions D1 and D2. Each of the first active pattern AP(1) and the second active pattern AP(2) may have a substantially uniform width W1. The width W1 of the first active pattern AP(1) and the second active pattern AP(2) may be several nanometers to several tens nanometers, although embodiments are not limited thereto. For example, the width W1 of the first active pattern AP(1) and the second active pattern AP(2) may be 1 nm to 30 nm, more preferably 1 nm to 10 nm. The length of each of the first active pattern AP(1) and the second active pattern AP(2) may be larger than the line width of the bit line (BL). In one example, each of the first AP(1) and third AP(3) active patterns may be perpendicular to an upper surface of the first structure PS.

Referring to FIG. 5B, each of the first active pattern AP(1) and the second active pattern AP(2) may have a first surface S1 and a second surface S2 that are opposite to each other in a third direction D3 perpendicular to the first direction D1 and the second direction D2. In one example, the first surfaces S1 of the first active pattern AP(1) and the second active pattern AP(2) may be in contact with the polysilicon pattern 161 of the bit line BL, and when the polysilicon pattern 161 is omitted, the first surfaces S1 may be in contact with the metal pattern 163.

Each of the first active pattern AP(1) and the second active pattern AP(2) may have a first side SS1 and a second side SS2 that are opposite to each other in the second direction D2. The first side SS1 of the first active pattern AP(1) may be adjacent to the first word line WL(1), and the second side SS2 of the second active pattern AP(2) may be adjacent to the second word line WL(2). In one example, the first word line WL(1) may extend in a first direction parallel to an upper surface of the first structure PS.

Each of the first active pattern AP(1) and the second active pattern AP(2) may include a first dopant region SDR1 adjacent to the bit line BL, a second dopant region SDR2 adjacent to the storage node contact BC, and a channel region CHR between the first and second dopant regions SDR1 and SDR2. The first and second dopant regions SDR1 and SDR2 may be regions doped with a dopant in the first active pattern AP(1) and the second active pattern AP(2), and a dopant concentration in the first active pattern AP(1) and the second active pattern AP(2) may be greater than a dopant concentration in the channel region CHR.

A portion of the word line WL adjacent to one active pattern AP may serve as a gate electrode, and the first and second dopant regions SDR1 and SDR2 doped within the one active pattern AP may serve as source/drain regions, and thus the selection element TR or the vertical channel transistor in FIG. 1B may be provided.

The channel regions CHR of the first active pattern AP(1) and the second active pattern AP(2) may be controlled by the first and second word lines WL(1) and WL(2), respectively, and the back gate lines BGL during operation of the semiconductor memory device. As the first active pattern AP(1) and the second active pattern AP(2) are formed of a single crystal semiconductor material, leakage current characteristics may be improved during operation of the semiconductor memory device.

Referring to FIGS. 4 and 5B, the back gate lines BGL may be disposed to be spaced apart from each other at a certain distance in the second direction D2 on the bit lines BL. The back gate lines BGL may extend in the first direction D1 across the bit lines BL.

Each of the back gate lines BGL may be disposed between a pair of first active patterns AP(1) and second active patterns AP(2) adjacent to each other in the second direction D2. That is, the first active pattern AP(1) may be disposed on one side of each of the back gate lines BGL, and the second active pattern AP(2) may be disposed on the other side. The back gate lines BGL may have a height smaller than a height of the first active pattern AP(1) and the second active pattern AP(2) in the vertical direction D3.

The back gate line BGL may have a first surface close to the bit line BL and a second surface, opposite the first surface in the third direction D3, close to the storage node contact BC. The first and second surfaces of the back gate line BGL may be vertically spaced apart from the first and second surfaces S1 and S2 of the first active pattern AP(1) and the second active pattern AP(2).

A level of an upper surface of each of the back gate lines BGL may be the same as or different from a level of an upper surface of each of the word lines WL, in the third direction D3, relative to the upper surface of the substrate 100 as a reference layer. A level of a lower surface of each of the back gate lines BGL may be the same as or different from a level of a lower surface of each of the word lines WL, in the third direction D3, relative to the upper surface of the substrate 100 as a reference layer.

The back gate lines BGL may be formed of, for example, doped polysilicon, a conductive metal nitride (e.g., titanium nitride, tantalum nitride, etc.), a metal (e.g., tungsten, titanium, tantalum, etc.) conductive metal silicide, a conductive metal oxide, or a combination thereof.

During operation of the semiconductor memory device, a negative voltage may be applied to the back gate lines BGL, and the threshold voltage of the vertical channel transistor may be increased. That is, as the vertical channel transistor is miniaturized, the threshold voltage may decrease, thereby preventing deterioration of leakage current characteristics.

The second upper insulating layer IL2 may include layers 111, 115, GOX1, GOX2, 131, 141, 143, 153, and 155 formed of an insulating material. The first insulating pattern 111 may be disposed between the first active pattern AP(1) and the second active pattern AP(2), which are adjacent to each other in the second direction D2. The first insulating pattern 111 may be disposed between the second dopant regions SDR2 of the first active pattern AP(1) and the second active pattern AP(2). The first insulating pattern 111 may include, for example, a silicon oxide layer, a silicon oxynitride layer, or a silicon nitride layer.

A first back gate insulating layer GOX2 may be disposed between the back gate line BGL and the first and second active patterns AP(1) and AP(2) in the second direction D2, and between the back gate line BGL and the first insulating pattern 111, respectively, in the third direction D3. The first back gate insulating layer GOX2 may include vertical portions covering both sides of the back gate line BGL and horizontal portions connecting the vertical portions. The horizontal portion of the first back gate insulating layer GOX2 may be closer to the storage node contact BC than the bit line BL and may cover the second side of the back gate line BGL.

Referring to FIGS. 5A and 5B, the first back gate insulating layer GOX2 may be formed of, for example, a silicon oxide layer, a silicon oxynitride layer, a high-k dielectric layer having a higher dielectric constant than the silicon oxide layer, or a combination thereof. The first back gate insulating layer GOX2 may have a second thickness T2 in the second direction D2.

A back gate capping pattern 115 may be disposed between the bit lines BL and the back gate line BGL in the third direction D3. The back gate capping pattern 115 may be formed of an insulating material, and a lower surface of the back gate capping pattern 115 may be in contact with the polysilicon pattern 161 of the bit lines BL. The back gate capping pattern 115 may be disposed between vertical portions of the first back gate insulating layer GOX2. A thickness of the back gate capping pattern 115 between the bit lines BL may be different from a thickness of the back gate capping pattern 115 on the bit lines BL.

Referring to FIGS. 5A and 5B, the first word line WL(1) and the second word line WL(2) may include, for example, doped polysilicon, a metal, a conductive metal nitride, a conductive metal silicide, a conductive metal oxide, or a combination thereof. Cell gate insulating layers GOX1 may be disposed between the first and second word lines WL(1) and WL(2) and the first and second active patterns AP(1) and AP(2). The cell gate insulating layers GOX1 may extend in the first direction D1 to be parallel to the first and second word lines WL(1) and WL(2). The cell gate insulating layers GOX1 may have a first thickness T1 in the second direction D2. The first thickness T1 may be the same as or different from the second thickness T2.

The cell gate insulating layer GOX1 may be formed of a silicon oxide layer, a silicon oxynitride layer, a high-dielectric constant (high-k) dielectric layer having a higher dielectric constant than the silicon oxide layer, or a combination thereof. The high-k dielectric layer may be formed of metal oxide or metal oxynitride. For example, the high-k dielectric layer that may be used as a gate insulating layer may be formed of HfO2, HfSiO, HfSiON, HfTaO, HfTiO, HfZrO, ZrO₂, Al₂O₃, or a combination thereof, but is not limited thereto.

The cell gate insulating layer GOX1 may cover the first side SS1 of the first active pattern AP(1) and the second side SS2 of the second active pattern AP(2). The term "cover" (or "covering," or like terms), as may be used herein, is intended to broadly refer to an element, structure or layer that is on or over another element, structure or layer, either directly or with one or more other intervening elements, structures or layers therebetween. The cell gate insulating layer GOX1 may have a substantially uniform thickness. Each of the cell gate insulating layers GOX1 may include a vertical portion VP adjacent to the first and second active patterns AP(1) and AP(2) and a horizontal portion HP protruding from the vertical portion VP in the second direction D2.

As an example, a pair of first and second word lines WL(1) and WL(2) may be disposed on the horizontal portion HP of each of the cell gate insulating layers GOX1. The cell gate insulating layers GOX1 may be spaced apart from each other and may be mirrored symmetrical to each other.

The second insulating pattern 143 may be disposed between the horizontal portion HP of the cell gate insulating layer GOX1 and the storage node contacts BC. As an example, the second insulating pattern 143 may include silicon oxide. First and second etch stop layers 131 and 141 may be disposed between the second dopant regions SDR2 of the first and second active patterns AP(1) and AP(2) and the second insulating pattern 143.

On the cell gate insulating layer GOX1, the first and second word lines WL(1) and WL(2) may be separated from each other by the third insulating pattern 155. The third insulating pattern 155 may extend in the first direction D1 between the first and second word lines WL(1) and WL(2). The first capping layer 153 may be disposed between the third insulating pattern 155 and the first and second word lines WL(1) and WL(2). The first capping layer 153 may have a substantially uniform thickness.

The third upper insulating layer IL3 may include an etch stop layer 210 and an interlayer insulating layer 231 that are sequentially stacked in the third direction D3. The storage node contacts BC may penetrate (i.e., extend into or through) the interlayer insulating layer 231 and the etch stop layer 210 and be electrically connected to the first and second active patterns AP(1) and AP(2), respectively. That is, the storage node contacts BC may be electrically connected to the second dopant regions SDR2 of the first and second active patterns AP(1) and AP(2), respectively. The storage node contacts BC may have a lower width greater than an upper width in the second direction D2. The storage node contacts BC adjacent to each other may be separated from each other by the fourth upper insulating layer IL4. Each of the storage node contacts BC may have various shapes such as, for example, circular, oval, rectangular, square, diamond, hexagonal, etc., when viewed in a plan view, although embodiments are not limited thereto. The storage node contacts BC are arranged in a matrix in the first direction D1 and the second direction D2. The storage node contacts BC may be formed of, for example, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but is not limited thereto.

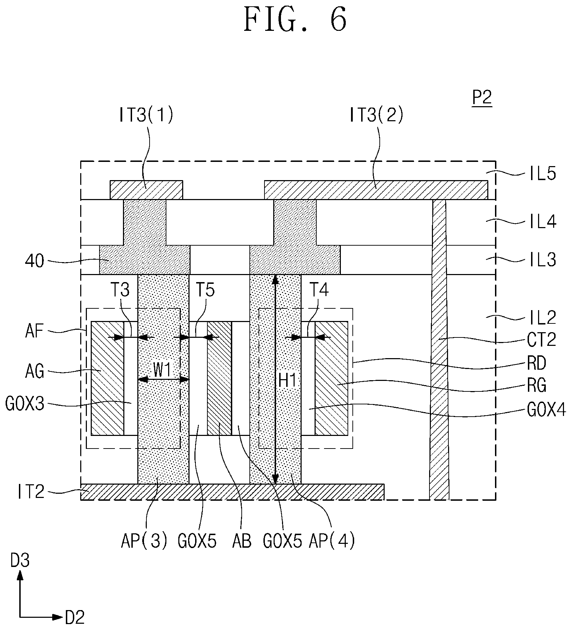

FIG. 6 is an enlarged view of `P2' in FIG. 3 according to embodiments of the inventive concept.

Referring to FIGS. 3 and 6, in the second peripheral circuit region Peri2, active patterns AP may penetrate (i.e., extend into or through) the second upper insulating layer IL2 in the third direction D3 and contact second upper wirings IT2. The active patterns AP may include a pair of third active patterns AP(3) and fourth active patterns AP(4) adjacent to each other in the second direction D2. Each of the third active pattern AP(3) and the fourth active pattern AP(4) has the same width W1 in the second direction D2 and height H1 in the third direction D3. In one example, the third active pattern AP(3) may have a same width W1 in the second direction D2 and a same height H1 in the third direction D3 as the first active pattern AP(1).

An anti-fuse gate electrode AG is disposed on one side of the third active pattern AP(3), opposite the fourth active pattern AP(4) in the second direction D2. A peripheral back gate electrode AB is interposed between the third active pattern AP(3) and the fourth active pattern AP(4). A read gate electrode RG is disposed on one side of the fourth active pattern AP(4), opposite the third active pattern AP(3) in the second direction D2. Although not shown in FIG. 6, the third active pattern AP(3) and the fourth active pattern AP(4) include first and second dopant regions SDR1 and SDR2, and a channel region CHR therebetween, respectively, like the first and second active patterns AP(1) and AP(2) of FIG. 5B.

Referring to FIG. 6, an anti-fuse gate insulating layer GOX3 may be interposed between the anti-fuse gate electrode AG and the third active pattern AP(3). A read gate insulating layer GOX4 may be interposed between the read gate electrode RG and the fourth active pattern AP(4). A second back gate insulating layer GOX5 may be interposed between the peripheral back gate electrode AB and the third active pattern AP(3) and between the peripheral back gate electrode AB and the fourth active pattern AP(4).

The anti-fuse gate electrode AG, the anti-fuse gate insulating layer GOX3, and the third active pattern AP(3) may constitute an anti-fuse transistor AF. The read gate electrode RG, the read gate insulating layer GOX4, and the fourth active pattern AP(4) may constitute a read transistor RD.

Referring to FIGS. 5A and 6, the anti-fuse gate insulating layer GOX3 may have a third thickness T3 in the second direction D2. The read gate insulating layer GOX4 may have a fourth thickness T4 in the second direction D2. The second back gate insulating layer GOX5 may have a fifth thickness T5 in the second direction D2. The third thickness T3 may be the same as or different from the fourth thickness T4 and the fifth thickness T5, respectively.

The third thickness T3 of the anti-fuse gate insulating layer GOX3 may be equal to or smaller than the first thickness T1 of the cell gate insulating layer GOX1. As a result, during a programming operation in which a high voltage is applied to the gate electrode of the anti-fuse element, the anti-fuse gate insulating layer GOX3 may be easily destroyed, thereby allowing the programming operation to proceed easily.

Conductive patterns 40 may be disposed on the third active pattern AP(3) and the fourth active pattern AP(4), respectively. The conductive patterns 40 may be formed of the same material as the storage node contacts BC. In the third direction D3, relative to the upper surface of the substrate 100 as a reference layer, the conductive patterns 40 may be positioned at the same level as the storage node contacts BC and may have the same cross section.

Referring again to FIGS. 3 and 5A, landing pads LP may be disposed on the storage node contacts BC. Each of the landing pads LP may have various shapes, such as a circle, an oval, a rectangle, a square, a diamond, or a hexagon, when viewed in a plan view, although embodiments are not limited thereto. The landing pads LP may completely or partially vertically overlap the storage node contacts BC. The landing pads LP may be arranged in a matrix form in the first direction D1 and the second direction D2 when viewed in a plan view. Alternatively, the landing pads LP may be arranged in a honeycomb shape when viewed in a plan view. The landing pads LP may be formed of, for example, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but is not limited thereto.

Referring to FIGS. 3 and 6, third upper wirings IT3 are disposed on the conductive patterns 40 and the fourth upper insulating layer IL4. The third upper wiring IT3(1) connected to the third active pattern AP(3) may be electrically floated. The third upper wiring IT3(2) connected to the fourth active pattern AP(4) may extend onto an upper surface of the fourth upper insulating layer IL4.

A second upper contact plug CT2 may penetrate (i.e., extend in) at least a portion of the first to fourth upper insulating layers IL1 to IL4 and may electrically connect the third upper wirings IT3 to the first upper wirings IT1 or the upper connection pads CCP2.

Referring to FIG. 3, lower electrodes BE of the capacitors CAP may be respectively disposed on the landing pads LP. The lower electrodes BE may be electrically connected to the first and second active patterns AP(1) and AP(2), respectively. Each of the lower electrodes BE may have a pillar shape or a hollow cup shape.

The lower electrodes BE may be arranged in a matrix shape or in a honeycomb shape in the first direction D1 and the second direction D2. The lower electrodes BE may completely or partially overlap the landing pads LP. The lower electrodes BE may be in contact with all or portion of an upper surface of the landing pads LP. A spacing between the lower electrodes BE may be constant. The lower electrodes BE may penetrate (i.e., extend into) a portion of the fifth upper insulating layer IL5 and may be in contact with the landing pads LP, respectively. The lower electrodes BE may include at least one of polysilicon doped with impurities, metal, a metal oxide layer, and a metal nitride layer. The lower electrodes BE may preferably include a titanium nitride layer.

Upper sidewalls of the lower electrodes BE may be in partial contact with support patterns SSP. The support patterns SSP may prevent the lower electrodes BE from collapsing. The support patterns SSP may have a plate or mesh shape with a plurality of holes formed therein when viewed in a plan view. The support patterns SSP may be formed of one layer or two or more layers. The support patterns SSP may be formed of, for example, a single layer or a multilayer of at least one of silicon nitride (SiN), silicon boron nitride (SiBN), and silicon carbon nitride (SiCN), although embodiments are not limited thereto.

A dielectric layer DL conformally covers the lower electrodes BE and the support patterns SSP. The term "conformally" (or "conformal," or like terms), as may be used herein in the context of a material layer or coating, is intended to refer broadly to a material layer or coating having a substantially uniform cross-sectional thickness relative to the contour of a surface to which the material layer is applied. The dielectric layer DL covers an upper surface of the fifth upper insulating layer IL5. The dielectric layer DL may be formed as, for example, a single or multilayer of a silicon oxide layer or a metal oxide layer having a higher dielectric constant than a silicon oxide layer, such as an aluminum oxide layer. An upper electrode UE may be disposed on the dielectric layer DL. The upper electrode UE may be formed of a single-layer or multi-layer structure of at least one of a titanium nitride layer, a tungsten layer, an impurity-doped polysilicon layer, and an impurity-doped silicon germanium layer. A sidewall of the upper electrode UE may be aligned with a sidewall of the dielectric layer DL.

The lower electrodes BE, the dielectric layer DL, and the upper electrode UE may constitute capacitors CAP. The capacitors CAP may correspond to the data storage element DS of FIG. 1B. The capacitor CAP and the fifth upper insulating layer IL5 are covered with a sixth upper insulating layer IL6. A seventh upper insulating layer IL7 is disposed on the sixth upper insulating layer IL6. Fourth upper contact plugs CT4 and fourth upper wirings IT4 may be disposed in the seventh upper insulating layer IL7. The third upper contact plugs CT3 may connect the fourth upper wirings IT4 to the third upper wirings IT3 by penetrating (i.e., extending into or through) the fifth and sixth upper insulating layers IL5 and IL6.

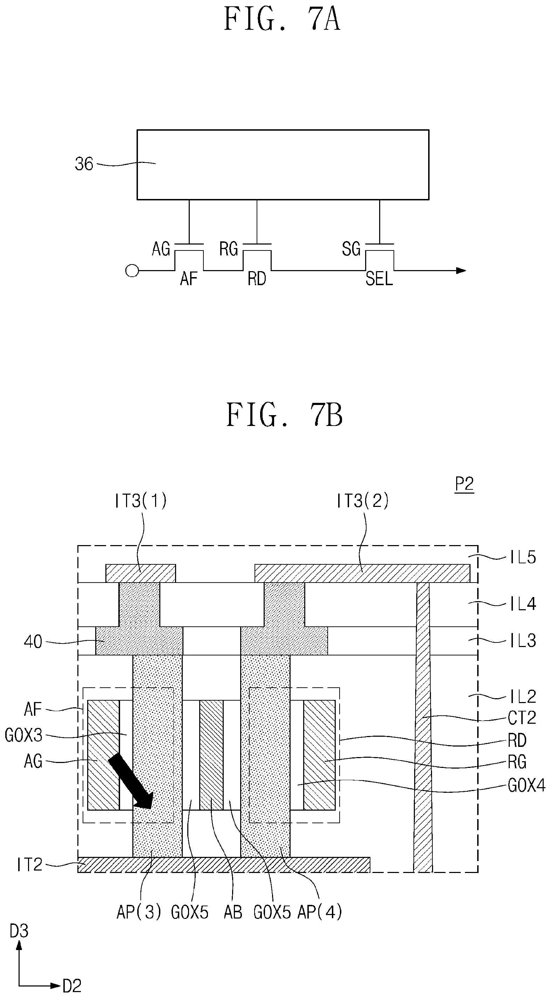

FIG. 7A is a schematic diagram depicting an illustrative anti-fuse circuit, according to embodiments of the inventive concept.

Referring to FIG. 7A, the anti-fuse circuit according to the inventive concept includes an anti-fuse transistor AF, a read transistor RD, and a selection transistor SEL electrically connected in series. The anti-fuse circuit may be arranged two-dimensionally in the first direction D1 and the second direction D2 or three-dimensionally in the first to third directions D1 to D3. An anti-fuse gate electrode AG of the anti-fuse transistor AF, a read gate electrode RG of the read transistor RD, and a selection gate electrode SG of the selection transistor SEL may be connected to the control logic 36.

Referring to FIGS. 6 and 7A, the anti-fuse transistor AF may be electrically connected to the read transistor RD through the second upper wiring IT2. The third upper wiring IT3(1) corresponding to one terminal of the anti-fuse transistor AF may be electrically floated (i.e., unconnected). The selection transistor SEL of FIG. 7A may be one of the third peripheral transistors PTR3 of FIG. 3. The read transistor RD may be connected to the selection transistor SEL through the conductive pattern 40, the third upper wiring IT3, and the second upper contact plug CT2. A first terminal of the selection transistor SEL may be connected to the read transistor RD, and a 0V or ground voltage may be applied to a second terminal of the selection transistor SEL. In a normal state, the anti-fuse gate insulating layer GOX3 of the anti-fuse transistor AF may be maintained in a normal state without destruction. As a result, there is no electrical signal detected through the read transistor RD and selection transistor SEL.

FIG. 7B is a schematic diagram illustrating a program operation of the anti-fuse transistor AF of FIG. 6.

Referring to FIGS. 7A and 7B, when a defective cell is found when inspecting a semiconductor memory device, a program operation is performed in which a high voltage (breakdown voltage, or fusing voltage) is applied from the control logic 36 to the anti-fuse gate electrode AG of the anti-fuse transistor AF. During the program operation, a turn-on voltage is applied from the control logic 36 to the read gate electrode RG of the read transistor RD and the selection gate electrode SG of the selection transistor SEL. Accordingly, 0V of the second terminal of the selection transistor SEL may be applied to the third active pattern AP(3), which is the channel region of the anti-fuse transistor AF. The anti-fuse gate insulating layer GOX3 may be destroyed as shown by the arrow in FIG. 7B due to a voltage difference between the anti-fuse gate electrode AG and the third active pattern AP(3). As a result, an electrical path (i.e., a resistive path or electrical short) is formed within the anti-fuse gate insulating layer GOX3.

After the program operation, a read operation may be performed. During the read operation, when an electrical signal is applied to the anti-fuse gate electrode AG and the read transistor RD and the selection transistor SEL are turned on, the electrical signal may be detected from the second terminal of the selection transistor SEL. As a result, the defective cell may be replaced with a redundancy cell.

In the semiconductor memory device according to the inventive concept, the second peripheral circuit region Peri2 including the anti-fuse circuits may be disposed between the cell array regions Cell1 to Cell8, thereby increasing integration and reducing the total horizontal area of the semiconductor memory device. In addition, the anti-fuse AF and read transistor RD may be implemented in a form of a vertical channel transistor by using the vertical active patterns AP(3) and AP(4) of the same as the vertical active patterns AP(1) and AP(2) of the cell array regions Cell1 to Cell 8. Therefore, while the horizontal area occupied by the anti-fuse circuits is reduced, a channel length may be increased. As a result, a semiconductor memory device that is highly integrated and has improved reliability may be provided.

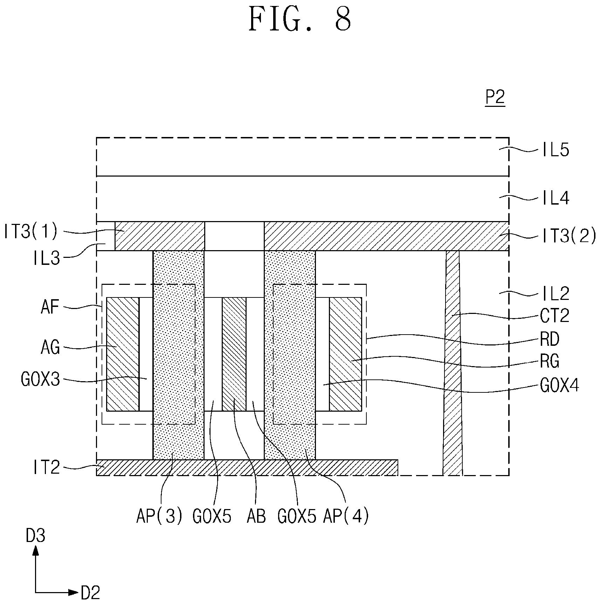

FIG. 8 is an enlarged view of region `P2' in FIG. 3, according to embodiments of the inventive concept.

Referring to FIG. 8, in a semiconductor memory device according to the present example, upper ends of the third and fourth active patterns AP(3) and AP(4) may be in direct contact with the third upper wirings IT3 (i.e., IT3(1) and IT3(2), respectively) without the conductive patterns 40 of FIG. 7B. Other configurations may be the same/similar to those described with reference to FIG. 7B.

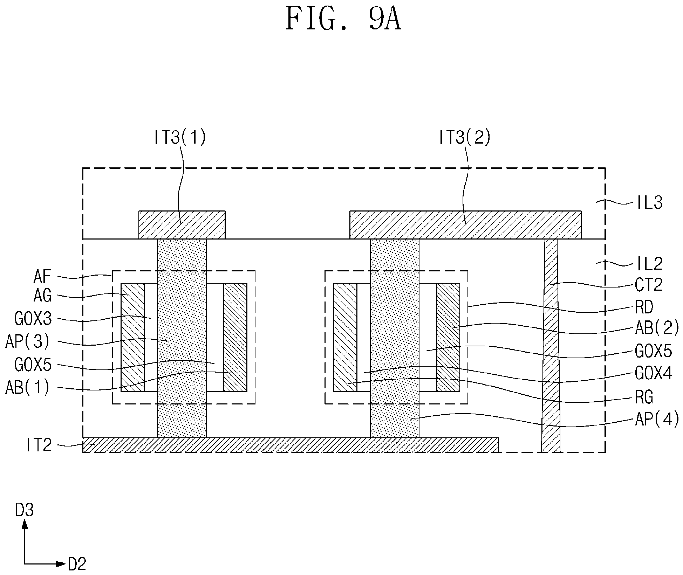

FIG. 9A is an enlarged view of region `P2' of FIG. 3, according to embodiments of the inventive concept.

Referring to FIG. 9A, according to the present example, the anti-fuse gate electrode AG is disposed on one side of the third active pattern AP(3). The anti-fuse gate insulating layer GOX3 is interposed between the third active pattern AP(3) and the anti-fuse gate electrode AG. A first peripheral back gate electrode AB(1) is disposed on the other side of the third active pattern AP(3), opposite the anti-fuse gate electrode AG in the second direction D2. A second back gate insulating layer GOX5 is interposed between the third active pattern AP(3) and the first peripheral back gate electrode AB(1). The third active pattern AP(3), the anti-fuse gate electrode AG, the anti-fuse gate insulating layer GOX3, the first peripheral back gate electrode AB(1), and the second back gate insulating layer GOX5 may constitute the anti-fuse transistor AF.

A read gate electrode RG is disposed on one side of the fourth active pattern AP(4). A read gate insulating layer GOX4 is interposed between the fourth active pattern AP(4) and the read gate electrode RG. A second peripheral back gate electrode AB(2) is disposed on the other side of the fourth active pattern AP(4), opposite the read gate electrode RG in the second direction D2. A second back gate insulating layer GOX5 is interposed between the fourth active pattern AP(4) and the second peripheral back gate electrode AB(2). A second upper insulating layer IL2 is interposed between the first peripheral back gate electrode AB(1) and the read gate electrode RG. The fourth active pattern AP(4), the read gate electrode RG, the read gate insulating layer GOX4, the second peripheral back gate electrode AB(2), and the second back gate insulating layer GOX5 may constitute a read transistor RD.

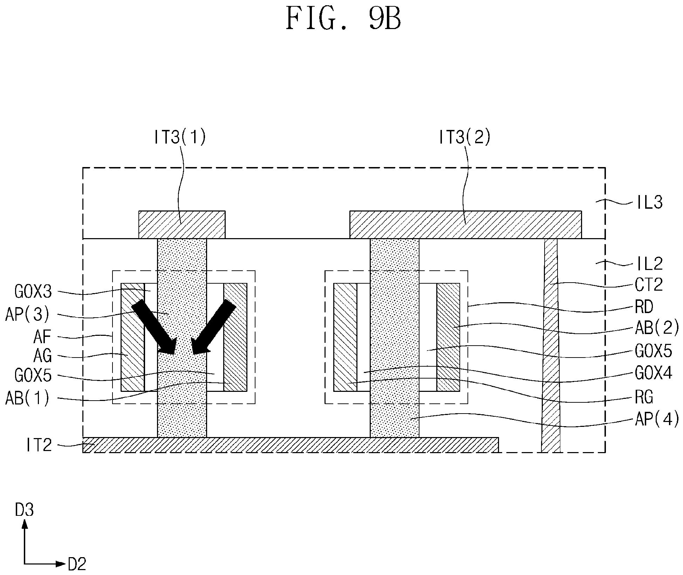

FIG. 9B is a schematic diagram illustrating a program operation of the anti-fuse transistor AF of FIG. 9A.

Referring to FIG. 9B, during a program operation, the same high voltage may be simultaneously applied to the anti-fuse gate electrode AG and the first peripheral back gate electrode AB(1). The anti-fuse gate insulating layer GOX3 and the second back gate insulating layer GOX5 disposed on both sides of the third active pattern AP(3) may be destroyed simultaneously, thereby forming electrical paths on both sides as indicated by corresponding arrows in FIG. 9B. Two electrical paths may be formed, and thus during a read operation, the amount of current may increase, and electrical signal may be well detected (e.g. may be easier to detect).

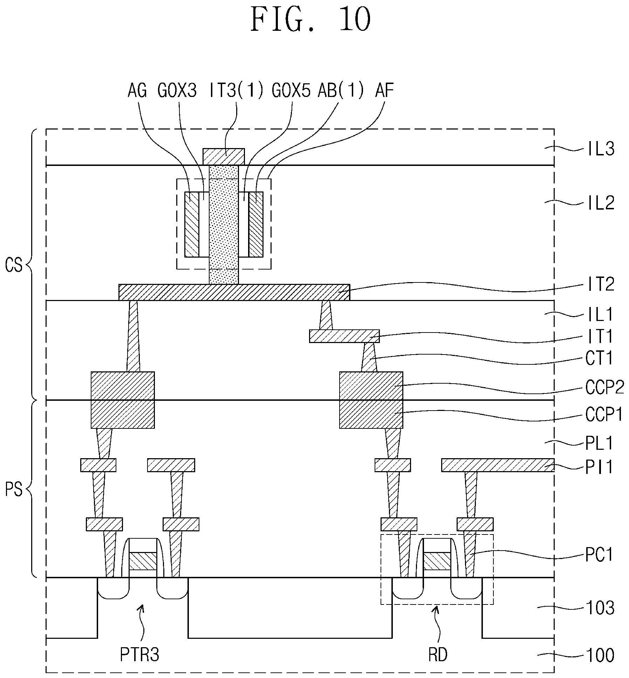

FIG. 10 is a schematic cross-sectional view illustrating a portion of a semiconductor memory device according to embodiments of the inventive concept.

Referring to FIG. 10, in the semiconductor memory device according to the present example, the anti-fuse transistor AF may be disposed on the second upper wiring IT2 of the second structure CS. The read transistor RD may be positioned at the same level as the third peripheral transistors PTR3 in the first structure PS. The anti-fuse transistor AF according to this example may have the same structure as the anti-fuse transistor AF of FIG. 9A. The read transistor RD may have the same structure as the third peripheral transistors PTR3. The anti-fuse transistor AF may be connected to the read transistor RD through the second upper wiring IT2, the first upper contact plug CT1, the first upper wiring IT1, the upper connection pad CCP2, the lower connection pad CCP1, the lower wiring PI1, and the lower contact plug PC1. Other structures may be the same/similar to those described above.

In the semiconductor memory device according to the inventive concept, the peripheral circuit regions including the anti-fuse circuits may be arranged between cell array regions, thereby increasing the integration and reducing the total horizontal area of the semiconductor memory device. Additionally, the anti-fuse transistor and the read transistor may be implemented in the form of the vertical channel transistor by using the active patterns of the same type as the vertical active patterns of the cell array regions. Therefore, the horizontal area occupied by the anti-fuse circuits may be reduced and the channel length may be increased. As a result, the semiconductor memory device that is highly integrated and has improved reliability may be provided.

Embodiments are set out in the following clauses:
1. A semiconductor memory device, comprising: a substrate; a first structure on the substrate and including core regions and a first peripheral circuit region; and a second structure on the first structure and including cell array regions and a second peripheral circuit region between the cell array regions, wherein the second structure further includes: a first active pattern in each of the cell array regions and perpendicular to an upper surface of the first structure; a word line adjacent to one side of the first active pattern and extending in a first direction parallel to the upper surface of the first structure; a bit line contacting a lower surface of the first active pattern and extending in a second direction parallel to the upper surface of the first structure and intersecting the first direction; a second active pattern in the second peripheral circuit region and perpendicular to the upper surface of the first structure; and an anti-fuse gate electrode on one side of the second active pattern.
2. The semiconductor memory device of clause 1, wherein the second structure further includes: a first gate insulating layer between the first active pattern and the word line and having a first thickness in the second direction; and a second gate insulating layer interposed between the second active pattern and the anti-fuse gate electrode and having a second thickness in the second direction, and wherein the second thickness is the same as or smaller than the first thickness.
3. The semiconductor memory device of clause 2, wherein the second gate insulating layer is configured such that an electrical path is formed when a high voltage is applied to the anti-fuse gate electrode.
4. The semiconductor memory device of any preceding clause 1, wherein the first active pattern has a same width, in the second direction, and height, in a third direction perpendicular to the upper surface of the first structure, as the second active pattern.
5. The semiconductor memory device of any preceding clause 1, wherein the second structure further includes a first peripheral back gate electrode spaced apart from the anti-fuse gate electrode, and the second active pattern is between the first peripheral back gate electrode and the anti-fuse gate electrode.
6. The semiconductor memory device of clause 5, wherein the second structure further includes: a third active pattern spaced apart from the second active pattern and perpendicular to the upper surface of the first structure, and the first peripheral back gate electrode is between the third active pattern and the second active pattern; and a read gate electrode spaced apart from the first peripheral back gate electrode, and the third active pattern is between the read gate electrode and the first peripheral back gate electrode.
7. The semiconductor memory device of clause 5, wherein the second structure further includes: a third active pattern spaced apart from the second active pattern and perpendicular to the upper surface of the first structure, and the first peripheral back gate electrode is between the third active pattern and the second active pattern; a first upper insulating layer between the first peripheral back gate electrode and the third active pattern; a read gate electrode between the first upper insulating layer and the third active pattern; a second peripheral back gate electrode spaced apart from the read gate electrode, and the third active pattern is between the second peripheral back gate electrode and the read gate electrode; a first gate insulating layer between the anti-fuse gate electrode and the second active pattern; and a second gate insulating layer between the first peripheral back gate electrode and the second active pattern.
8. The semiconductor memory device of clause 7, wherein each of the first gate insulating layer and the second gate insulating layer is configured such that an electrical path is formed therein when a high voltage is applied to the anti-fuse gate electrode and the first peripheral back gate electrode, respectively.
9. The semiconductor memory device of clause 7, wherein the second peripheral structure further includes: a second upper insulating layer below the bit line, relative to the upper surface of the first structure; a conductive line on the second upper insulating layer and in contact with a lower surface of the second active pattern; an upper connection pad at a lower surface of the second upper insulating layer; and an upper contact plug extending into the second upper insulating layer and electrically connecting the conductive line to the upper connection pad, and wherein the first structure further includes: a read transistor on the substrate; a lower insulating layer on the read transistor; a lower connection pad on an upper end of the lower insulating layer and contacting the upper connection pad; and a lower contact plug extending into the lower insulating layer and electrically connecting the lower connection pad to one terminal of the read transistor.
10. A semiconductor memory device, comprising: a substrate; and a first structure on the substrate and including cell array regions and a first peripheral circuit region between the cell array regions, wherein the first structure further includes: a first word line, a first active pattern, a back gate line, a second active pattern and a second word line arranged proximate to one another in a first direction parallel to an upper surface of the substrate in a corresponding one of the cell array regions; and an anti-fuse gate electrode, a third active pattern, and a first peripheral back gate electrode arranged proximate to one another in the first direction in the first peripheral circuit region, and wherein the first active pattern, the second active pattern, and the third active pattern extend longitudinally in a direction perpendicular to the upper surface of the substrate.
11. The semiconductor memory device of clause 10, wherein the first structure further includes: a first gate insulating layer between the first active pattern and the word line and having a first thickness; and a second gate insulating layer between the second active pattern and the anti-fuse gate electrode and having a second thickness, and wherein the second thickness is the same as or less than the first thickness.
12. The semiconductor memory device of clause 10 or 11, wherein the first to third active patterns have a same width, in the first direction, and height, in the direction perpendicular to the upper surface of the substrate.
13. The semiconductor memory device of clause 10, 11, or 12, further comprising a second structure between the substrate and the first structure, wherein the second structure includes core regions and a second peripheral circuit region, wherein the core regions at least partially vertically overlap the cell array regions, respectively, and wherein the second peripheral circuit region at least partially vertically overlaps the first peripheral circuit region.
14. The semiconductor memory device of clause 13, wherein the first peripheral structure further includes: a bit line in contact with lower surfaces of the first and second active patterns; an upper insulating layer below the bit line, relative to the upper surface of the substrate; a conductive line on the upper insulating layer and contacting a lower surface of the third active pattern; an upper connection pad at a lower end of the upper insulating layer; and an upper contact plug extending into the upper insulating layer and electrically connecting the conductive line to the upper connection pad, and wherein the second structure further includes: a read transistor on the substrate; a lower insulating layer on the read transistor; a lower connection pad on an upper end of the lower insulating layer and contacting the upper connection pad; and a lower contact plug extending into the lower insulating layer and electrically connecting the lower connection pad to one terminal of the read transistor.
15. The semiconductor memory device of any of clauses 10 to 14, wherein the first structure further includes: a fourth active pattern spaced apart from the third active pattern and perpendicular to the upper surface of the substrate, the first peripheral back gate electrode between the fourth active pattern and the third active pattern; and a read gate electrode spaced apart from the first peripheral back gate electrode, and the fourth active pattern is between the read gate electrode and the first peripheral back gate electrode.
16. The semiconductor memory device of any of clauses 10 to 15, wherein the first structure further includes: a fourth active pattern spaced apart from the third active pattern and perpendicular to the upper surface of the substrate, and the first peripheral back gate electrode is between the fourth active pattern and the third active pattern; an upper insulating layer between the first peripheral back gate electrode and the fourth active pattern; a read gate electrode between the upper insulating layer and the fourth active pattern; and a second peripheral back gate electrode spaced apart from the read gate electrode, and the fourth active pattern is between the second peripheral back gate electrode and the read gate electrode.
17. A semiconductor memory device, comprising: a substrate; a first structure on the substrate and including core regions and a first peripheral circuit region; and a second structure on the first structure and including cell array regions and a second peripheral circuit region between the cell array regions, wherein the cell array regions at least partially vertically overlap the core regions, respectively, wherein the second peripheral circuit region at least partially vertically overlaps the first peripheral circuit region, wherein the second structure further includes: a bit line extending in a first direction parallel to an upper surface of the substrate in the cell array region; a first word line, a first gate insulating layer, a first active pattern, a back gate line, a second active pattern, and a second word line proximate to one another in the first direction on the bit line; a conductive line in the second peripheral circuit region; an anti-fuse gate electrode, a second gate insulating layer, a third active pattern, and a first peripheral back gate electrode proximate to one another in the first direction on the conductive line, wherein the first active pattern, the second active pattern, and the third active pattern extend longitudinally in a vertical direction from the upper surface of the substrate, wherein the first word line, the back gate line, and the second word line extend in a second direction that intersects the first direction and is parallel to the upper surface of the substrate, wherein the first gate insulating layer has a first thickness, and wherein the second gate insulating layer has a second thickness that is equal to or less than the first thickness.
18. The semiconductor memory device of clause 17, wherein the second peripheral structure further includes: an upper insulating layer below the bit line in the vertical direction, relative to the upper surface of the substrate; a conductive line on the upper insulating layer and contacting a lower surface of the second active pattern; an upper connection pad at a lower end of the upper insulating layer; and an upper contact plug extending into the upper insulating layer and electrically connecting the conductive line to the upper connection pad, and wherein the first structure further includes: a read transistor on the substrate; a lower insulating layer on the read transistor; a lower connection pad on an upper end of the lower insulating layer and contacting the upper connection pad; and a lower contact plug extending into the lower insulating layer and electrically connecting the lower connection pad to one terminal of the read transistor.
19. The semiconductor memory device of clause 17 or 18, wherein the second structure further includes: a fourth active pattern spaced apart from the third active pattern and perpendicular to the upper surface of the substrate, and the first peripheral back gate electrode is between the fourth active pattern and the third active pattern; and a read gate electrode spaced apart from the first peripheral back gate electrode, and the fourth active pattern is between the read gate electrode and the first peripheral back gate electrode.
20. The semiconductor memory device of clause 17, 18 or 19, wherein the second structure further includes: a fourth active pattern spaced apart from the third active pattern and perpendicular to the upper surface of the substrate, and the first peripheral back gate electrode is between the fourth active pattern and the third active pattern; an upper insulating layer between the first peripheral back gate electrode and the fourth active pattern; a read gate electrode between the upper insulating layer and the fourth active pattern; and a second peripheral back gate electrode spaced apart from the read gate electrode, and the fourth active pattern is between the second peripheral back gate electrode and the read gate electrode.

While embodiments are described above, a person skilled in the art may understand that many modifications and variations are made without departing from the scope of the inventive concept defined in the following claims. Accordingly, the example embodiments of the inventive concept should be considered in all respects as illustrative and not restrictive, with the scope of the inventive concept being indicated by the appended claims. The embodiments of FIGS. 2 through 10 can be combined with each other.

## Claims

1. A semiconductor memory device, comprising:
a substrate;
a first structure on the substrate and including core regions and a first peripheral circuit region; and
a second structure on the first structure and including cell array regions and a second peripheral circuit region between the cell array regions,
wherein the second structure further includes:
a first active pattern in each of the cell array regions and perpendicular to an upper surface of the first structure;
a word line adjacent to one side of the first active pattern and extending in a first direction parallel to the upper surface of the first structure;
a bit line contacting a lower surface of the first active pattern and extending in a second direction parallel to the upper surface of the first structure and intersecting the first direction;
a second active pattern in the second peripheral circuit region and perpendicular to the upper surface of the first structure; and
an anti-fuse gate electrode on one side of the second active pattern.

2. The semiconductor memory device of claim 1, wherein the second structure further includes:
a first gate insulating layer between the first active pattern and the word line and having a first thickness in the second direction; and
a second gate insulating layer interposed between the second active pattern and the anti-fuse gate electrode and having a second thickness in the second direction, and
wherein the second thickness is the same as or smaller than the first thickness.

3. The semiconductor memory device of claim 2, wherein the second gate insulating layer is configured such that an electrical path is formed when a high voltage is applied to the anti-fuse gate electrode.

4. The semiconductor memory device of any preceding claim, wherein the first active pattern has a same width, in the second direction, and height, in a third direction perpendicular to the upper surface of the first structure, as the second active pattern.

5. The semiconductor memory device of any preceding claim, wherein the second structure further includes a first peripheral back gate electrode spaced apart from the anti-fuse gate electrode, and the second active pattern is between the first peripheral back gate electrode and the anti-fuse gate electrode.

6. The semiconductor memory device of claim 5, wherein the second structure further includes:
a third active pattern spaced apart from the second active pattern and perpendicular to the upper surface of the first structure, and the first peripheral back gate electrode is between the third active pattern and the second active pattern; and
a read gate electrode spaced apart from the first peripheral back gate electrode, and the third active pattern is between the read gate electrode and the first peripheral back gate electrode.

7. The semiconductor memory device of claim 5, wherein the second structure further includes:
a third active pattern spaced apart from the second active pattern and perpendicular to the upper surface of the first structure, and the first peripheral back gate electrode is between the third active pattern and the second active pattern;
a first upper insulating layer between the first peripheral back gate electrode and the third active pattern;
a read gate electrode between the first upper insulating layer and the third active pattern;
a second peripheral back gate electrode spaced apart from the read gate electrode, and the third active pattern is between the second peripheral back gate electrode and the read gate electrode;
a first gate insulating layer between the anti-fuse gate electrode and the second active pattern; and
a second gate insulating layer between the first peripheral back gate electrode and the second active pattern.

8. The semiconductor memory device of claim 7, wherein each of the first gate insulating layer and the second gate insulating layer is configured such that an electrical path is formed therein when a high voltage is applied to the anti-fuse gate electrode and the first peripheral back gate electrode, respectively.

9. The semiconductor memory device of claim 7 or 8, wherein the second peripheral structure further includes:
a second upper insulating layer below the bit line, relative to the upper surface of the first structure;
a conductive line on the second upper insulating layer and in contact with a lower surface of the second active pattern;
an upper connection pad at a lower surface of the second upper insulating layer; and
an upper contact plug extending into the second upper insulating layer and electrically connecting the conductive line to the upper connection pad, and
wherein the first structure further includes:
a read transistor on the substrate;
a lower insulating layer on the read transistor;
a lower connection pad on an upper end of the lower insulating layer and contacting the upper connection pad; and
a lower contact plug extending into the lower insulating layer and electrically connecting the lower connection pad to one terminal of the read transistor.
